# EUROPÄISCHE PATENTSCHRIFT

(11) **EP 1 857 569 B1**
(45) Veröffentlichungstag und Bekanntmachung des Hinweises auf die Patenterteilung: **19.05.2010**
(21) Anmeldenummer: 07108041.0
(22) Anmeldetag: 11.05.2007
(51) Int. Cl.: C23C 16/458, C23C 14/50

(54) **Plasmabehandlungsanlage**
Plasma processing system
Système de traitement par plasma

(30) Priorität: 18.05.2006 DE 202006007937 U
(43) Veröffentlichungstag der Anmeldung: 21.11.2007
(73) Patentinhaber: Strämke, Siegfried, Dr., 52499 Baesweiler (DE)
(72) Erfinder: Strämke, Siegfried, Dr., 52499 Baesweiler (DE)
(74) Vertreter: von Kreisler Selting Werner

(56) Entgegenhaltungen:
- DE-U1- 20 320 846
- JP-A- 5 271 931
- JP-A- 2002 198 412
- US-A1- 2003 164 143

## Beschreibung

Die Erfindung betrifft eine Plasmabehandlungsanlage mit Werkstückträgern zur Aufnahme von Werkstücken, die einer Plasmabehandlung, z.B. einer Plasmanitrierung unterzogen oder im Plasmareaktor mit einer Beschichtung versehen werden.

Die in einer Plasmaanlage zu behandelnden Werkstücke, die einer Wärmebehandlung oder Beschichtung unterzogen werden, müssen mit einem definierten Abstand von z.B. 1cm chargiert werden. Dies erfolgt normalerweise manuell und erfordert viel Zeit, was zu einer schlechten Ausnutzung der Anlage führt. Man hat bereits das Chargieren, d.h. das Einbringen der Werkstücke in den Werkstückträger, außerhalb des Plasmareaktors vorgenommen und den beladenen Werkstückträger anschließend mit einem Kran manuell oder automatisch in den Plasmareaktor verfahren. Dies erfordert ebenfalls eine aufwändige Anlagentechnik und trägt nicht zu einer wesentlichen Reduzierung des Zeitaufwandes bei.

Aus JP 2002-198412A ist eine Vorrichtung zur Oberflächenbehandlung von Halbleiterwafern bekannt, bei der zwischen Prozesskammern und Speicherkammern eine Transferkammer vorgesehen ist. Die Transferkammer 4 enthält einen Greifer, der durch Schleusen sowohl auf eine Speicherkammer als auch auf eine Prozesskammer zugreifen kann. Jede Prozesskammer enthält ein Gestell zur Positionierung der Halbleiterwafer. Das Gestell ist von einer Haube umgeben. Es wird von der jeweiligen Prozesskammer in die Haube hinein angehoben.

Die US-A-2003/0164143 offenbart eine Plasmabehandlungsanlage mit drehbaren werkstückträger, wobei die werkstücke unter einer Haube angeordnet sind.

Der Erfindung liegt die Aufgabe zugrunde, eine Plasmabehandlungsanlage derart auszubilden, dass ein besserer Ausnutzungsgrad bei relativ geringem technischen Aufwand erzielt wird.

Die erfindungsgemäße Plasmabehandlungsanlage ist durch den Anspruch 1 bezeichnet. Sie weist mindestens zwei Werkstückträger auf, von denen jeder mit einer Haube bedeckt werden kann, um einen abgedichteten Behandlungsraum zu schließen, in dem die Plasmabehandlung stattfindet. Während der eine Werkstückträger von dem Manipulator mit Werkstücken bestückt wird, erfolgt an dem anderen Werkstückträger die Plasmabehandlung. Der Werkstückträger bildet zusammen mit der Haube einen Plasmareaktor.

Vorzugsweise ist der Werkstückträger mit einem Sockel oder Boden versehen, der mit der Haube abdichtend verbindbar ist. Der Werkstückträger bildet also einen Bestandteil der Hülle des Plasmareaktors, die durch Aufsetzen der Haube vervollständigt wird.

Gemäß einer bevorzugten Ausgestaltung der Erfindung ist vorgesehen, dass ein Manipulator mindestens vier Werkstückträger derart bedient, dass abwechselnd zwei der Werkstückträger offen und zwei andere mit je einer Haube bedeckt sind. Ein derartiges System hat den Vorteil einer besseren Nutzung des Manipulators, bei dem es sich in der Regel um einen aufwändigen Roboter handelt. Dieser kann hier vier (oder mehr) Plasma-Zellen aus Werkstückträger und Haube bedienen. Generell kann jeder Werkstückträger mit einer eigenen Haube versehen sein, die entweder angehoben oder abgesenkt wird. Eine Verringerung des Aufwandes ergibt sich, wenn jeweils zwei Werkstückträger dieselbe Haube abwechselnd benutzen.

Die Plasma-Zelle kann mit Zusatzaggregaten, die vorteilhaft ebenfalls von dem Manipulator bedient bzw. unterstützt werden, bestückt werden. So kann eine Ein- und Ausschraubstation integriert werden, die Aufhängeschrauben, die im System umlaufen, in die Werkstücke ein- und ausdreht, damit die Werkstücke in dem Werkstückträger aufgehängt werden können. Auch kann der Manipulator Palettier- und Depalettieraufgaben übernehmen.

Im Folgenden werden unter Bezugnahme auf die Zeichnungen Ausführungsbeispiele der Erfindung näher erläutert.

Es zeigen:
- Figur 1: eine schematische Darstellung einer ersten Ausführungsform der Plasmabehandlungsanlage,
- Figur 2: eine zweite Ausführungsform der Plasmabehandlungsanlage mit insgesamt vier Plasma-Zellen und
- Figur 3: die Plasmabehandlungsanlage nach Fig. 2 mit zusätzlichen Hilfsaggregaten.

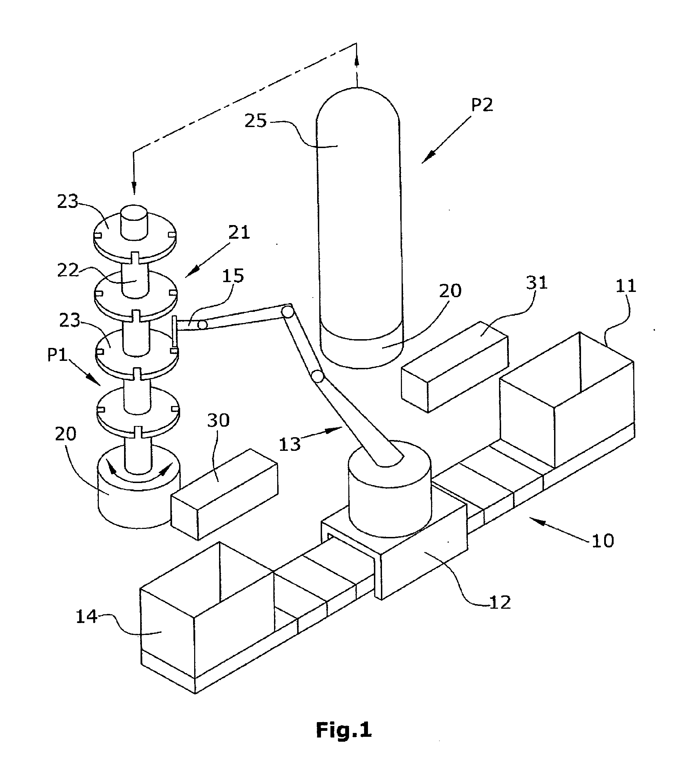

Die in Fig. 1 dargestellte Plasmabehandlungsanlage weist einen Förderer 10 auf, auf dem Behälter 11, welche die Werkstücke enthalten, transportiert werden. Der Förderer 10 läuft hier unter einer Brücke 12 hindurch, die einen Manipulator 13 trägt. Der Manipulator entnimmt die Werkzeuge dem Behälter 11, um sie einer der beiden Plasma-Zellen zuzuführen. Nach erfolgter Behandlung entnimmt der Manipulator die Werkzeuge wieder der Plasma-Zelle und führt sie in den Ausgangsbehälter 14 ein. Der Manipulator ist ein gesteuerter Roboter mit mindestens drei Bewegungsachsen, dessen Roboterhand 15 sämtliche genannten Zielpositionen erreichen kann.

Im vorliegenden Fall sind zwei Plasma-Zellen P1 und P2 vorhanden, die stationär angeordnet sind. Jede der Plasma-Zellen enthält einen stationären Sockel 20 oder Boden, der einen aufragenden Werkstückträger 21 trägt. Der Werkstückträger 21 enthält eine gesteuert drehbare vertikale Achse 22, an der in unterschiedlichen Höhen Tragböden 23 angebracht sind, an welchen die einzelnen Werkstücke aufgehängt werden können. Der Werkstückträger wird durch eine (nicht dargestellte) Potentialklemme an ein elektrisches Potential gelegt, das auf die einzelnen Werkstücke übertragen wird. Eine Gegenelektrode ist in dem Behandlungsraum enthalten.

Der Behandlungsraum wird durch eine Haube 25 abgeschlossen. Diese Haube schließt druckdicht an den Sockel 20 an. Sie kann durch eine gesteuerte Umsetzvorrichtung automatisch angehoben und von einem Sockel 20 zu einem anderen umgesetzt werden, so dass eine Haube 25 für zwei Plasma-Zellen P1,P2 vorhanden ist.

Die Werkstücke, die von dem Manipulator 13 einzeln entnommen werden, können mit Hilfsmitteln bestückt werden. So ist ein Zusatzgerät 30 vorgesehen, das eine Schraubstation bildet, an der dem Werkstück eine Schraube zur Ermöglichung des Aufhängens des Werkstücks an dem Werkstückträger 21 eingeschraubt wird. Im Anschluss an die Behandlung übernimmt das Zusatzgerät 30 auch wieder das Abschrauben der Schraube von dem Werkstück.

Ein weiteres Zusatzgerät 31 führt eine Laserbeschriftung der Werkstücke durch, die ihm von dem Manipulator 13 zugeführt werden.

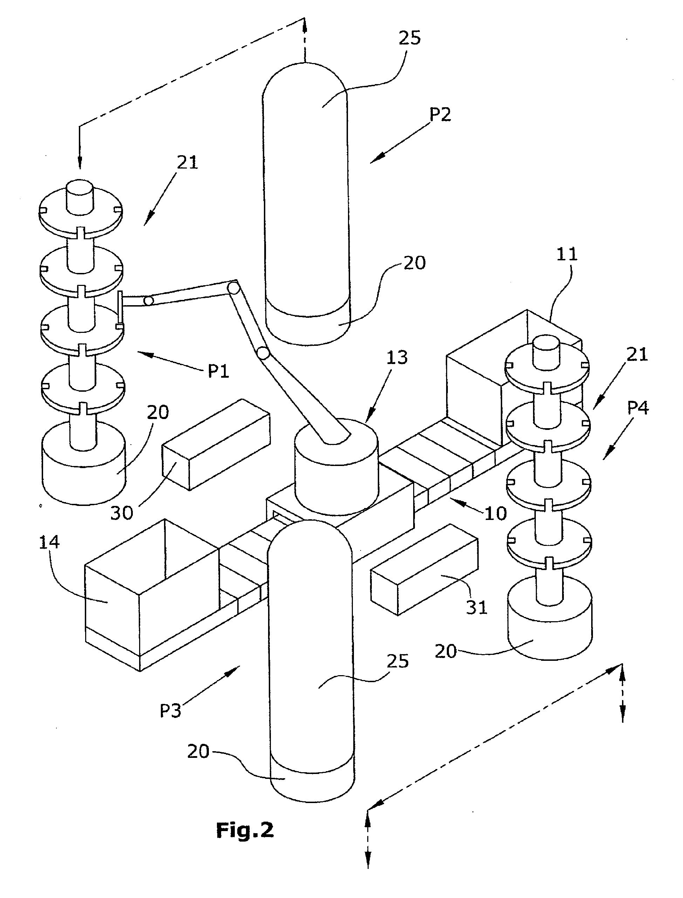

Bei dem Ausführungsbeispiel von Fig. 2 bedient der Manipulator 13 insgesamt vier Plasma-Zellen P1,P2,P3,P4. Die Plasma-Zellen P1 und P2 sind wie bei dem ersten Ausführungsbeispiel auf einer Seite des Förderers 10 angeordnet und die beiden anderen Plasma-Zellen auf der gegenüberliegenden Seite. Der Manipulator 13 ist im geometrischen Mittelpunkt der vier Plasma-Zellen angeordnet, so dass er jede der Plasma-Zellen erreichen kann.

Die Plasma-Zellen sind in gleicher Weise ausgebildet wie bei dem ersten Ausführungsbeispiel, d.h. jede Plasma-Zelle weist einen Werkstückträger 21 auf und zwei Plasma-Zellen P1 und P2 teilen sich eine Haube 25, welche umsetzbar ist. Die beiden anderen Plasma-Zellen P3 und P4 teilen sich ebenfalls eine Haube 25, welche umsetzbar ist. Jede der Plasma-Zellen ist über ihren Sockel mit einer Saugquelle verbunden, so dass sie evakuiert werden kann. Außerdem können durch (nicht dargestellte) Leitungen Gase in den jeweiligen Behandlungsraum eingeleitet werden.

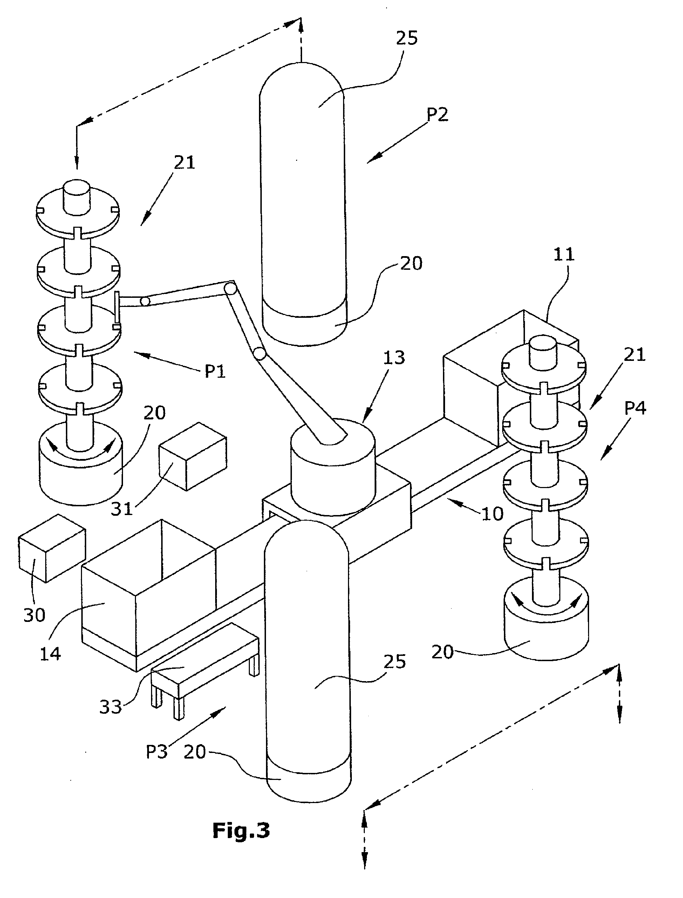

Das Ausführungsbeispiel von Fig. 3 entspricht demjenigen von Fig. 2, wobei außerdem noch die in Fig. 1 erläuterten Zusatzgeräte 30 und 31 vorhanden sind. Ein weiteres Zusatzgerät 33 ist ein Ausschleuseförderer, mit dem die behandelten Gegenstände abgefördert werden können.

## Patentansprüche

1. Plasmabehandlungsanlage mit mindestens zwei Plasma-Zellen (P1, P2) mit je einem um seine jeweilige Achse gesteuert drehbaren stationären Werkstückträger (21) mit in unterschiedlichen Höhen angeordneten Tragböden (23) zum Tragen von Werkstücken zu deren Behandlung und einer auf einem Werkstückträger (21) aufsetzbaren Haube (25) und mit einem Manipulator (13) zum automatischen Beladen der Tragböden (23) eines Werkstückträgers (21) mit Werkstücken,
wobei eine Haube (25) für zwei Plasma-Zellen (P1, P2) vorhanden ist, die mit einer Umsetzvorrichtung von einem zu dem anderen Werkzeugträger (21) umsetzbar ist und imstande ist, jeden der beiden Werkstückträger zur Bildung eines abgedichteten Behandlungsraumes zur Durchführung der Plasmabehandlung der Werkstücke zu umschließen, während der andere Werkstückträger zum automatischen Beladen offen ist.

2. Plasmabehandlungsanlage nach Anspruch 1, **dadurch gekennzeichnet, dass** der Werkstückträger (21) an einem stationären Sockel (20) befestigt ist, mit dem die Haube (25) abdichtend verbindbar ist.

3. Plasmabehandlungsanlage nach Anspruch 1 oder 2, **dadurch gekennzeichnet, dass** ein Manipulator (13) mindestens vier Werkstückträger bedient, wobei abwechselnd zwei der Werkstückträger (21) offen und zwei andere mit je einer Haube (25) bedeckt sind.

4. Plasmabehandlungsanlage nach einem der Ansprüche 1-3, **dadurch gekennzeichnet, dass** der Manipulator (13) die Werkstücke mit Hilfseinrichtungen versieht, bevor er sie mit dem Werkstückträger (21) verbindet.

5. Plasmabehandlungsanlage nach Anspruch 4, **dadurch gekennzeichnet, dass** die Hilfseinrichtungen aus Aufhängevorrichtungen bestehen.

6. Plasmabehandlungsanlage nach Anspruch 4, **dadurch gekennzeichnet, dass** die Hilfseinrichtungen Abdeckmittel zum partiellen Abdecken der Werkstückoberfläche sind.

7. Plasmabehandlungsanlage nach einem der Ansprüche 1-6, **dadurch gekennzeichnet, dass** der Manipulator (13) eine Bearbeitung der Werkstücke vornimmt.

8. Plasmabehandlungsanlage nach einem der Ansprüche 1-7, **dadurch gekennzeichnet, dass** der Manipulator (13) derart gesteuert ist, dass er die Werkstücke vor oder nach dem Beladen des Werkstückträgers einer Bearbeitungsstation in Form eines Zusatzgerätes (30,31) zuführt.

9. Plasmabehandlungsanlage nach einem der Ansprüche 1-8, **dadurch gekennzeichnet, dass** der Manipulator (13) die behandelten Werkstücke auf Paletten überträgt.

## Claims

1. A plasma treatment installation comprising at least two plasma cells (P1, P2) each having a stationary work piece holder (21) adapted for controlled rotation about its respective axis and having supporting plates (23), arranged at different heights, for supporting workpieces for the treatment thereof, and comprises at least one hood (25) to be set on a workpiece holder (21), and a manipulator (13) for automatically equipping the supporting plates (23) of a workpiece holder (21) with workpieces,
wherein one hood (25) is provided for two plasma cells (P1, P2), which is adapted to be transferred from one work piece holder (21) to another by means of a transferring device, and which hood is adapted to enclose each of the two workpiece holders to form a sealed treatment space to perform the plasma treatment of the workpieces, while the other workpiece holder is open for being automatically loaded.

2. The plasma treatment installation of claim 1, **characterized in that** the workpiece holder (21) is fastened to a stationary base (20) with which the hood (25) can be connected in a sealing manner.

3. The plasma treatment installation of claim 1 or 2, **characterized in that** a manipulator (13) serves at least four workpiece holders such that, alternately, two of the workpiece holders (21) are open and two others are covered by a respective hood (25).

4. The plasma treatment installation of one of claims 1-3, **characterized in that** the manipulator (13) provides the workpieces with auxiliary equipment before connecting them with the workpiece holder (21).

5. The plasma treatment installation of claim 4, **characterized in that** the auxiliary equipment are suspension devices.

6. The plasma treatment installation of claim 4, **characterized in that** the auxiliary equipment are covering means for partially covering the workpiece surfaces.

7. The plasma treatment installation of one of claims 1-6, **characterized in that** the manipulator (13) processes the workpieces.

8. The plasma treatment installation of one of claims 1-7, **characterized in that** the manipulator (13) is controlled such that it supplies the workpieces to a processing station in the form of an auxiliary device (30, 31) prior to or after loading the workpiece holder.

9. The plasma treatment installation of one of claims 1-8, **characterized in that** the manipulator (13) transfers the treated workpieces onto pallets.

## Revendications

1. Système de traîtement par plasma comprenant au moins deux cellules de plasma (P1, P2), chacune avec un support de pièce à fabriquer (21) stationnaire et rotatif sous contrôle autour de son axe, comprenant des plaques de support (23) sur des niveaux différents pour supporter des pièces à fabriquer pour leur traîtement et un capot (25) apte à être placé sur un support de pièce à fabriquer (21), et avec un manipulateur (13) pour automatiquement équiper les plaques de support (23) d'un support de pièce à fabriquer (21) avec des pièces à fabriquer,
dans lequel un capot (25) est prévu pour deux cellules de plasma (P1, P2), le capot étant apte à être transféré de l'un des supports de pièce à fabriquer (21) sur l'autre par un dispositif de transfert et étant apte à envelopper chacun des deux supports de pièce à fabriquer pour former un espace de traîtement pour l'exécution du traîtement par plasma sur les pièces à fabriquer, tandis que l'autre support de pièce à fabriquer est ouvert pour être équipé automatiquement.

2. Système de traîtement par plasma selon la revendication 1, **caractérisé en ce que** le support de pièce à fabriquer (21) est attaché à une embase stationnaire (20), avec laquelle embase ledit capot (25) peut être connecté d'une manière étanche.

3. Système de traîtement par plasma selon la revendication 1 ou 2, **caractérisé en ce qu'**un manipulateur (13) sert au moins quatre supports de pièce à fabriquer, dans lequel, alternativement, deux des supports de pièce à fabriquer (21) sont ouverts et les deux autres sont chacun couverts par un capot (25).

4. Système de traîtement par plasma selon l'une quelconque des revendications 1-3, **caractérisé en ce que** ledit manipulateur (13) munit les pièces à fabriquer de moyens auxiliaires avant qu'il les attache audit support de pièce à fabriquer (21).

5. Système de traîtement par plasma selon la revendication 4, **caractérisé en ce que** les moyens auxiliaires sont formés par des moyens de suspension.

6. Système de traîtement par plasma selon la revendication 4, **caractérisé en ce que** les moyens auxiliaires sont des moyens couvrants servant à partiellement couvrir la surface de la pièce à fabriquer.

7. Système de traîtement par plasma selon l'une quelconque des revendications 1-6, **caractérisé en ce que** ledit manipulateur (13) performe le traîtement des pièces à fabriquer.

8. Système de traîtement par plasma selon l'une quelconque des revendications 1-7, **caractérisé en ce que** ledit manipulateur (13) est commandé de manière qu'il amène les pièces à fabriquer, avant ou après l'équipement d'un support de pièce à fabriquer, à une station de traîtement en forme d'un appareil auxiliaire (30, 31).

9. Système de traîtement par plasma selon l'une quelconque des revendications 1-8, **caractérisé en ce que** le manipulateur (13) transfert les pièces à fabriquer traitées sur des palettes.
